# EUROPÄISCHE PATENTSCHRIFT

(11) **EP 1 252 627 B1**
(45) Veröffentlichungstag und Bekanntmachung des Hinweises auf die Patenterteilung: **17.12.2003**
(21) Anmeldenummer: 00990585.2
(22) Anmeldetag: 29.12.2000
(51) Int. Cl.: G11C 5/14

(54) **ANORDNUNG ZUR SPANNUNGSVERSORGUNG EINES FLÜCHTIGEN HALBLEITERSPEICHERS**
ARRANGEMENT FOR VOLTAGE SUPPLY TO A VOLATILE SEMICONDUCTOR MEMORY
DISPOSITIF D'ALIMENTATION EN TENSION D'UNE MEMOIRE A SEMI-CONDUCTEURS VOLATILE

(30) Priorität: 30.12.1999 DE 19964018
(43) Veröffentlichungstag der Anmeldung: 30.10.2002
(73) Patentinhaber: ROBERT BOSCH GMBH, 70442 Stuttgart (DE)
(72) Erfinder: ZIMMERMANN, Christian, 72072 Tübingen (DE); AUE, Axel, 70825 Korntal-Muenchingen (DE); SPACHMANN, Juergen, 74372 Sersheim (DE)
(86) Internationale Anmeldenummer: DE0004636
(87) Internationale Veröffentlichungsnummer: WO01050473

(56) Entgegenhaltungen:
- EP-A- 0 871 178
- FR-A- 2 738 682
- US-A- 5 182 468

## Beschreibung

### Stand der Technik

Die vorliegende Erfindung betrifft eine Anordnung zur Spannungsversorgung eines flüchtigen Halbleiterspeichers gemäß dem Oberbegriff des unabhängigen Anspruchs.

Halbleiterspeicher gliedern sich in die beiden Gruppen flüchtige und nicht flüchtige Speicher. Flüchtige Speicher (Kurzzeitspeicher) sind beliebig häufig auslesbar und beschreibbar und werden daher z.B. als Random Access Memories (RAM) bezeichnet. Ihr Informationsinhalt geht beim Abschalten der Versorgungsspannung verloren. Nicht flüchtige Speicher (Langzeitspeicher) halten ihren Informationsinhalt auch nach Abschalten der Versorgungsspannung und werden auch als Festwertspeicher bezeichnet.

Ein flüchtiger Halbleiterspeicher ist bspw. Teil eines Mikrorechners. In dem Speicherarray des Halbleiterspeichers wird ein von dem Mikrorechner abarbeitbares Programm gespeichert. Wenn der Mikrorechner Teil eines Steuergeräts für ein Kraftfahrzeug, bspw. Teil eines Motorsteuergeräts, ist, muss der Informationsinhalt des Speicherarrays auch nach dem Abstellen des Kraftfahrzeugs dauerhaft gespeichert werden. Dazu wird eine Versorgungsspannung für den Halbleiterspeicher vorgesehen, die permanent, also insbesondere auch bei abgeschaltetem Kraftfahrzeug, an dem Halbleiterspeicher anliegt.

Die Dauerspannungsversorgung zur permanenten Speicherung des Informationsinhalts des Speicherarrays wird insbesondere aus der Fahrzeugbatterie gebildet und führt aufgrund der Ruhestromaufnahme zu einer langsamen Entladung der Fahrzeugbatterie. Außerdem unterscheidet sich die Stromaufnahme des Halbleiterspeichers in der dauerversorgten Ruhephase um mehrere Zehnerpotenzen von der Stromaufnahme im Normalbetrieb, in dem Schreib-/Lesezugriffe ausgeführt werden. Deshalb wird üblicherweise eine aufwendige Anordnung zur Spannungsversorgung des Halbleiterspeichers vorgesehen, die aus zwei Schaltungsteilen mit unterschiedlicher Treiberfähigkeit für den Ruhebetrieb und den Normalbetrieb besteht. Bei Bedarf wird zwischen den beiden Schaltungsteilen umgeschaltet. Der Schaltungsteil mit der hohen Treiberfähigkeit für den Normalbetrieb muss im Stillstand des Kraftfahrzeugs abgeschaltet werden, damit die Ruhestromaufnahme möglichst gering ist, da es sonst zu einer raschen Leerung der Fahrzeugbatterie kommt. Der Schaltungsteil mit der kleinen Treiberfähigkeit für die Ruhephase besitzt aufgrund seiner Komplexität bei aus dem Stand der Technik bekannten Realisierungen aber dennoch eine Ruhestromaufnahme von z.B. mehreren 100 Mikroampere.

Der Schaltungsteil mit der kleinen Treiberfähigkeit muss die Eingangsspannung bzw. Standbyspannung des Halbleiterspeichers stabilisieren, damit es aufgrund von Schwankungen, insbesondere aufgrund eines Absinkens, der Versorgungsspannung des Speicherarrays nicht zu einem Rücksetzen (Reset) des Halbleiterspeichers und infolge dessen zu einem vollständigen Verlust der in dem Speicherarray abgelegten Informationen kommt. Des weiteren sollte der Schaltungsteil mit der kleinen Treiberfähigkeit das Speicherarray vor Überspannungsimpulsen schützen, um eine Beschädigung des Speicherarrays und einen damit verbundenen Informationsverlust zu vermeiden.

Daneben ist aus der FR-A-2 738 682 eine Anordnung zur Spannungsversorgung einer MOS-Schaltung bekannt, bei der zur Versorgung eine Eingangsspannung eines vorbestimmten Wertes anliegt, und die eine Stabilisierungsschaltung als Überspannungsschutz enthält, die bei Überschreiten der Eingangsspannung über den vorbestimmten Wert niederohmiger und bei Rückgang der Eingangsspannung in Richtung auf den vorbestimmten Wert hochohmiger ist.

Der vorliegenden Erfindung liegt die Aufgabe zugrunde, eine Anordnung zur Spannungsversorgung eines Halbleiterspeichers möglichst einfach und mit möglichst wenigen Bauelementen zu realisieren, damit die Ruhestromaufnahme der Anordnung möglichst gering ist.

Zur Lösung dieser Aufgabe schlägt die Erfindung ausgehend von der Anordnung zur Spannungsversorgung der im Oberbegriff des Anspruchs 1 genannten Art vor, dass in dem Halbleiterspeicher eine Stabilisierungsschaltung zur Stabilisierung der Eingangsspannung der im Kennzeichnenden Teil der Anspruchs 1 genannten Art vorgesehen ist.

Insbesondere ist dies erfindungsgemäß durch eine Parallelschaltung einer Diode und eines Transistors erzielbar, wobei die Diode mit ihrer Anode an der Eingangs- bzw. Standbyspannung und mit ihrer Kathode an einem Bezugspotential angeschlossen ist, das an einem dritten Anschluss des Halbleiterspeichers anliegt, und wobei der Transistor mit seiner Schaltstrecke, also dem Kanal Drain-Source bei einem Feldeffekttransistor (FET) oder der Emitter-Kollektor-Strecke bei einem Bipolartransistor zwischen der Standbyspannung und dem Bezugspotential angeschlossen ist und die Basis des Transistors, also das Gate bei einem Feldeffekttransistor (FET) oder die Basis bei einem Bipolartransistor an der Eingangs- bzw. Standbyspannung anliegt. Im Weiteren werden die Begriffe Eingangsspannung und Standbyspannung gleichermassen verwendet.

### Vorteile der Erfindung

Die erfindungsgemäße Anordnung weist eine besonders einfach aufgebaute Stabilisierungsschaltung auf.

Sie besteht in einem bevorzugten Ausführungsbeispiel lediglich aus einer Diode und einem Transistor, die in geeigneter Weise miteinander verschaltet sind, um eine optimale Stabilisierung der Standbyspannung zu erzielen. die Stabilisierungsschaltung der erfindungsgemäßen Anordnung ist in den Halbleiterspeicher integriert. Die erfindungsgemäßen Anordnung macht sich die Tatsache zu Nutze, dass an die Stabilität der Standbyspannung nur relativ geringe Anforderungen gestellt werden müssen, um einen Erhalt der Informationen in dem Speicherarray sicherzustellen.

Weitere Möglichkeiten die Stabilisierungsschaltung zu realisieren sind die Verwendung einer Z-Diode, eine spannnungsabhängige Leitfähigkeitssteuerung eines CMOS Transistors oder eine temperaturkompensierte, spannnungsabhängige Leitfähigkeitssteuerung.

Aufgrund des einfachen Aufbaus und der geringen Anzahl von Bauelementen der Stabilisierungsschaltung kann der Arbeitsstrom zur Stabilisierung der Versorgungsspannung in der Ruhephase des Halbleiterspeichers besonders klein gewählt werden, wodurch die Ruhestromaufnahme sehr gering gehalten werden kann. Einer Fahrzeugbatterie wird somit in der Ruhephase des Halbleiterspeichers besonders wenig Strom entzogen und sie wird geschont.

Die Diode der Stabilisierungsschaltung ist vorteilhafterweise als eine Zener-Diode ausgebildet. Der Transistor der Stabilisierungsschaltung ist vorteilhafterweise als ein FET, insbesondere MOSFET, ausgebildet. Vorzugsweise ist der Transistor als ein n-Kanal-Feldeffekttransistor ausgebildet.

Gemäß einer bevorzugten Ausführungsform der vorliegenden Erfindung wird vorgeschlagen, dass der zweite Anschluss des Halbleiterspeichers über einen Widerstand mit einer Versorgungsspannungsquelle verbunden ist. Die Versorgungsspannungsquelle ist bspw. als eine Autobatterie ausgebildet. Über den Widerstand fällt ein Teil der Versorgungsspannung ab und es liegt die Standbyspannung an dem zweiten Anschluss des Halbleiterspeichers an. Bei der erfindungsgemäßen Anordnung kann der Widerstand besonders hochohmig gewählt werden, da ein sehr kleiner Arbeitsstrom zur Stabilisierung der Standbyspannung mittels der Stabilisierungsschaltung genügt.

Zur Glättung der Standbyspannung und zur Überbrückung kurzer Einbrüche der Versorgungsspannung ist der zweite Anschluss des Halbleiterspeichers vorteilhafterweise über einen Kondensator mit dem Bezugspotential verbunden.

Schließlich wird gemäß einer weiteren bevorzugten Ausführungsform der vorliegenden Erfindung vorgeschlagen, dass in dem Halbleiterspeicher eine Schutzschaltung bestehend aus einer Reihenschaltung von mehreren Klammerelementen vorgesehen ist, die zwischen der Standbyspannung und dem Bezugspotential angeordnet ist. Mit Hilfe dieser Schutzschaltung kann der Speicherarray vor Überspannungsimpulsen geschützt werden. Die Klammerspannung der Schutzschaltung kann durch die Wahl einer entsprechenen Anzahl von Klammerelementen eingestellt werden.

Die Klammerelemente sind vorteilhafterweise als Transistoren ausgebildet, die über den Kanal Drain-Source miteinander in Reihe geschaltet sind, wobei das Gate der Transistoren jeweils mit dem Drain oder dem Source des jeweiligen Transistors verbunden ist. Die Transistoren der Schutzschaltung sind vorzugsweise als MOSFETs ausgebildet. Schließlich sind die Transistoren der Schutzschaltung als n-Kanal-Feldeffekttransistoren ausgebildet.

### Zeichnung

Ein bevorzugtes Ausführungsbeispiel der vorliegenden Erfindung wird im Folgenden anhand der in der Zeichnung dargestellten Figuren näher erläutert. Es zeigen:
- Figur 1: eine erfindungsgemäße Anordnung zur Spannungsversorgung eines flüchtigen Halbleiterspeichers.
- Figur 2: zeigt nochmals das erfindungsgemäße Prinzip schematisch in einer Anordnung in allgemeinerer Form.

### Beschreibung der Ausführungsbeispiele

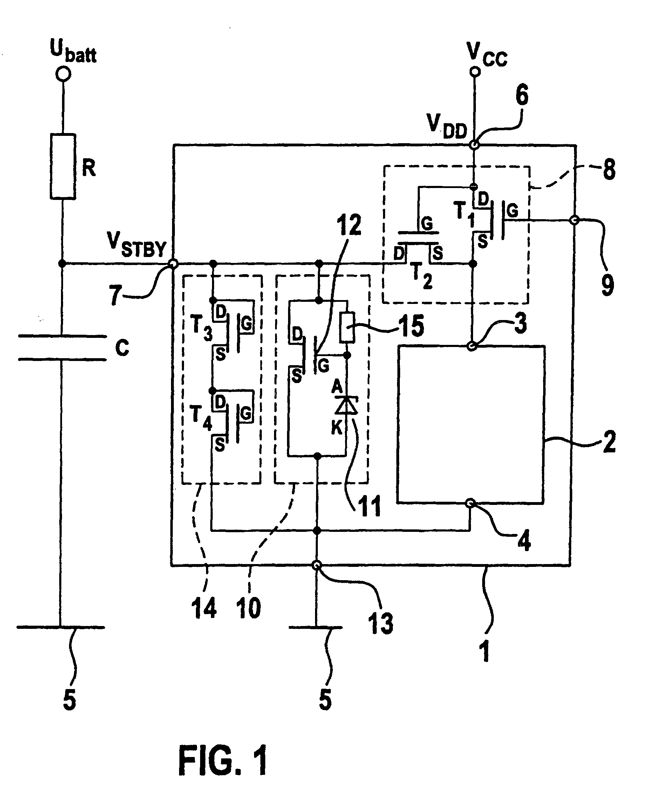

In Fig. 1 ist ein flüchtiger Halbleiterspeicher in seiner Gesamtheit mit dem Bezugszeichen 1 bezeichnet. Der Halbleiterspeicher 1 weist ein Speicherarray 2 auf, in dem eine Vielzahl von Speicherzellen matrixartig angeordnet sind. Zur Auswahl einer bestimmten Speicherzelle zum Schreiben von Informationen in die Speicherzelle oder zum Lesen des Inhalts der Speicherzelle wird die Adresse der Speicherzelle von einem Spalten- bzw. Zeilendecoder dekodiert.

Der flüchtige Halbleiterspeicher 1 ist Teil eines Mikrorechners (nicht dargestellt). Dieser wiederum ist Teil eines Steuergeräts für ein Kraftfahrzeug, bspw. Teil eines Motorsteuergeräts. In dem Speicherarray 2 des Halbleiterspeichers 1 ist ein von dem Mikrorechner abarbeitbares Steuerprogramm gespeichert. Um nach dem Abstellen des Kraftfahrzeugs einen Verlust des Steuerprogramms zu verhindern, muss der Informationsinhalt des Speicherarrays 2 auch nach dem Abstellen des Kraftfahrzeugs dauerhaft gespeichert werden. Dazu wird eine Versorgungsspannung für das Speicherarray 2 vorgesehen, die permanent, also insbesondere auch bei abgeschaltetem Kraftfahrzeug, anliegt. Die Versorgungsspannung liegt an einem ersten Anschluss 3 des Speicherarrays 2 an. Ein zweiter Anschluss 4 des Speicherarrays 2 ist an ein Bezugspotential 5 angeschlossen.

Die Stromaufnahme des Halbleiterspeichers 1 in der dauerversorgten Ruhephase unterscheidet sich um mehrere Zehnerpotenzen von der Stromaufnahme im Normalbetrieb, in dem Schreib-/ Lesezugriffe ausgeführt werden. Deshalb ist eine Anordnung zur Spannungsversorgung des Halbleiterspeichers 1 vorgesehen, die aus zwei Schaltungsteilen mit unterschiedlicher Treiberfähigkeit für den Ruhebetrieb und den Normalbetrieb besteht. In dem vorliegenden Ausführungsbeispiel entspricht die Betriebsspannung V_DD für den Normalbetrieb der in dem Steuergerät intern erzeugten Spannung V_CC. Die Standbyspannung V_STBY für die Ruhephasen liegt an einem zweiten Anschluss 7 des Halbleiterspeichers 1 an. Die Standbyspannung V_STBY entspricht der Batteriespannung U_batt, die um eine an einem Widerstand R abfallende Spannung reduziert ist.

Bei Bedarf wird mittels einer Umschaltanordnung 8 zwischen den beiden Schaltungsteilen, bzw. zwischen der Betriebsspannung V_DD und der Standbyspannung (V_STBY), umgeschaltet. Der Schaltungsteil mit der hohen Treiberfähigkeit für den Normalbetrieb muss im Stillstand des Kraftfahrzeugs abgeschaltet werden, damit die Ruhestromaufnahme möglichst gering ist, da es sonst zu einer raschen Leerung der Fahrzeugbatterie kommt. Die Umschaltanordnung 8 weist zwei Transistoren T_1, T_2 auf. Der erste Transistor T_1 (n-Kanal-Transistor) ist mit seinem Kanal Drain-Source DS zwischen der Betriebsspannung V_DD und dem ersten Anschluss 3 des Speicherarrays 2 für die Versorgungsspannung und mit seinem Gate G an einem vierten Anschluss 9 des Halbleiterspeichers 1 angeschlossen. An dem vierten Anschluss 9 liegt ein Schaltsignal zum Umschalten der Versorgungsspannung an. Als Schaltsignal kann eine Steuergerät-interne Spannung verwendet werden, so dass beim Abschalten des Steuergeräts automatisch von der Betriebsspannung V_DD auf die Standbyspannung V_STBY umgeschaltet wird. Der zweite Transistor T_2 ist mit seinem Kanal Drain-Source DS zwischen dem ersten Anschluss 3 des Speicherarrays 2 und dem zweiten Anschluss 7 des Halbleiterspeichers 1 und mit seinem Gate G an dem ersten Anschluss 6 des Halbleiterspeichers 1 angeschlossen.

In dem Halbleiterspeicher 1 ist eine Stabilisierungsschaltung 10 zur Stabilisierung der Eingangsspannung bzw. Standbyspannung V_STBY vorgesehen. Die Stabilisierungsschaltung 10 umfasst eine Parallelschaltung einer Diode 11 und eines Transistors 12. Die Diode 11 ist mit ihrer Anode A über einen Widerstand 15 an dem zweiten Anschluss 7 des Halbleiterspeichers 1 und mit ihrer Kathode K über einen dritten Anschluss 13 des Halbleiterspeichers 1 an das Bezugspotential angeschlossen. Die Diode 11 ist als eine Zener-Diode ausgebildet. Der Transistor 12 ist mit seinem Kanal Drain-Source DS zwischen dem zweiten Anschluss 7 und dem dritten Anschluss 13 des Halbleiterspeichers 1 und mit seinem Gate G über den Widerstand 15 an den zweiten Anschluss 7 des Halbleiterspeichers 1 angeschlossen. Der Transistor 12 ist als ein n-Kanal MOSFET ausgebildet.

Zur Glättung der Eingangsspannung bzw. der Standbyspannung V_STBY und zur Überbrückung kurzer Einbrüche der Batteriespannung U_batt ist der zweite Anschluss 7 des Halbleiterspeichers 1 über einen Kondensator C mit dem Bezugspotential 5 verbunden.

Zum Schutz des Speicherarrays 2 vor Überspannungsimpulsen ist in dem Halbleiterspeicher 1 eine Schutzschaltung 14 bestehend aus einer Reihenschaltung von zwei Transistoren T_3, T_4 vorgesehen. Die Transistoren T_3, T_4 sind über den Kanal Drain-Source DS zwischen dem zweiten Anschluss 7 und dem dritten Anschluss 13 des Halbleiterspeichers 1 miteinander in Reihe geschaltet. Das Gate G der Transistoren T_3, T_4 ist jeweils mit dem Drain D oder dem Source S des jeweiligen Transistors T_3; T_4 verbunden. Die Transistoren T_3, T_4 der Schutzschaltung 14 sind als n-Kanal MOSFETs ausgebildet.

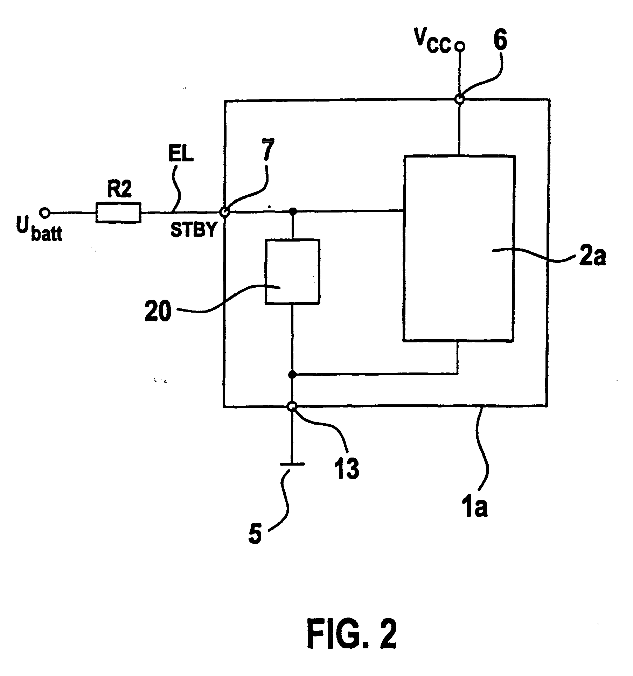

In Figur 2 ist nochmals das erfindungsgemäße Prinzip schematisch in allgemeinerer Form dargestellt. Dabei ist mit Ubatt wieder die Versorgungsspannungsquelle, z.B. als Batterie bzw. Batteriespannung dargestellt. Diese Versorgungsspannung kann dabei für den erfindungsgemäßen Gegenstand als unstabilisierte Versorgungsspannung vorliegen, was den Aufwand wiederum reduziert.

Mit R2 ist in Figur 2 ein Verbraucher, insbesondere ein Widerstand, dargestellt. Dieser ist über eine Eingangsleitung EL in den Speicherschaltkreis 1a mit der Stabilisierungsschaltung 20 verbunden. Der Speicherschaltkreis entspricht dabei in allgemeinerer Darstellung dem Halbleiterspeicher 1, welcher ein lediglich konkreteres Ausführungsbeispiel des erfindungsgemäßen Gegenstandes darstellt. 2a stellt in allgemeinerer Form den füchtigen Speicher selbst, insbesondere als RAM (Random Access Memory), dar, welcher in dieser Darstellung ebenfalls Schaltungsteile, wie z.B. die Umschaltanordnung 8 aus Figur 1 zusätzlich zum Speicherarray 2 enthalten kann.

Die Reduzierung der Eingangsspannung V_STBY an Punkt 7 wird dadurch erreicht, dass ein höherer Strom über den Widerstand R2 gezogen wird. Die Eingangsspannung V_STBY an Punkt 7 in Figur 2 wird gemessen. Überschreitet die Eingangsspannung V_STBY über EL einen vorgebbaren oder bestimmten Wert, wird die Stabilisierungsschaltung 20 niederohmiger, wodurch mehr Strom gezogen wird und über den Widerstand R2 eine höhere Spannung abfällt. Dadurch wird die Eingangsspannung V_STBY geringer.
Wird die Eingangsspannung V_STBY für die Versorgung des internen flüchtigen Speichers 2a zu gering, dann wird die Stabilisierungsschaltung 20 hochohmiger, wodurch die Spannung am Eingang (7) V_STBY wieder ansteigt, da weniger Spannung über den Widerstand R2 abfällt.

Die allgemeine Funktion der Stabilisierungschaltung 20 ebenso wie der Schaltung 10 in Figur 1 besteht somit darin, bei erhöhter Eingangsspannung V_STBY niederohmiger und bei zu geringer Eingangsspannung V_STBY hochohmiger zu werden.

Diese Funktionalität läßt sich durch die Schaltung 10 ebenso erzielen wie beispielsweise durch eine Z-Diode, eine spannnungsabhängige Leitfähigkeitssteuerung eines CMOS Transistors, eine temperaturkompensierte, spannnungsabhängige Leitfähigkeitssteuerung, usw.

Mit verschiedenen Schaltungen kann somit der erfindungsgemäße Gegenstand realisiert werden, weshalb die Erfindung in ihrer Ausführung auch nicht auf die oben genannten bevorzugten Ausführungsbeispiele beschränkt ist. Vielmehr ist eine Anzahl von Varianten denkbar, welche von der dargestellten Lösung auch bei anders gearteten Ausführungen Gebrauch macht.

## Patentansprüche

1. Anordnung zur Spannungsversorgung eines flüchtigen Halbleiterspeichers (1, 1a) mit einem Speicherarray (2, 2a), wobei an dem Halbleiterspeicher (1, 1a) eine Eingangsspannung (V_STBY) eines vorgebbaren oder bestimmten Wertes zur Versorgung des Halbleiterspeichers an einem zweiten Anschluss (7) anliegt, **dadurch gekennzeichnet, dass** in dem Halbleiterspeicher (1, 1a) eine Stabilisierungsschaltung (10, 20) zur Stabilisierung der Eingangsspannung (V_STBY) vorgesehen ist, die bei erhöhter Eingangsspannung (V_STBY) über dem vorgebbaren oder bestimmten Wert niederohmiger und bei zu geringer Eingangsspannung (V_STBY) unter dem vorgebbaren oder bestimmten Wert hochohmiger ist.

2. Anordnung nach Anspruch 1, **dadurch gekennzeichnet, dass** die Stabilisierungsschaltung als eine Parallelschaltung einer Diode (11) und eines Transistors (12) ausgebildet ist, wobei die Diode (11) mit ihrer Anode (A) an der Eingangsspannung (V_STBY) und mit ihrer Kathode (K) an einem Bezugspotential (5) angeschlossen ist, das an einem dritten Anschluss (13) des Halbleiterspeichers (1) anliegt, und wobei der Transistor (12) mit seiner Schaltstrecke (DS) zwischen der Eingangsspannung (V_STBY) und dem Bezugspotential (5) angeschlossen ist und die Basis (G) des Transistors (12) an der Eingangsspannung (V_STBY) anliegt.

3. Anordnung nach Anspruch 1, **dadurch gekennzeichnet, dass** eine Umschaltanordnung (8) zum Umschalten einer Versorgungsspannung zwischen einer Betriebsspannung (V_DD), die an einem ersten Anschluss (6) des Halbleiterspeichers (1, 1a) anliegt, und der Eingangsspannung (V_STBY), die an dem zweiten Anschluss (7) des Halbleiterspeichers (1, 1a) anliegt, angeordnet ist

4. Anordnung nach Anspruch 1, **dadurch gekennzeichnet, dass** die Diode (11) als eine Zener-Diode ausgebildet ist.

5. Anordnung nach Anspruch 1, **dadurch gekennzeichnet, dass** der zweite Anschluss (7) des Halbleiterspeichers (1, 1a) über einen Widerstand (R, R2) mit einer Versorgungsspannung (Ubatt) verbunden ist.

6. Anordnung nach Anspruch 1, **dadurch gekennzeichnet, dass** der zweite Anschluss (7) des Halbleiterspeichers (1) über einen Kondensator (C) mit dem Bezugspotential (5) verbunden ist.

7. Anordnung nach Anspruch 1, **dadurch gekennzeichnet, dass** in dem Halbleiterspeicher (1) eine Schutzschaltung (14) bestehend aus einer Reihenschaltung von mehreren Klammerelementen (T_3, T_4) vorgesehen ist, die zwischen der Eingangsspannung (V_STBY) und dem Bezugspotential (5) angeordnet ist.

8. Anordnung nach Anspruch 7, **dadurch gekennzeichnet, dass** die Klammerelemente als Transistoren (T_3, T_4) ausgebildet sind, die über die Schaltstrecke (DS) miteinander in Reihe geschaltet sind, wobei die Basis (G) der Transistoren (T_3, T_4) jeweils mit einem Anschluss der Schaltstrecke (D, S) des jeweiligen Transistors (T_3; T_4) verbunden ist.

9. Anordnung nach Anspruch 2 oder 8, **dadurch gekennzeichnet, dass** der Transistor (12) oder die Transistoren (T_3; T_4) der Schutzschaltung als ein Feldeffekt- (MOSFET) oder ein Bipolartransistor ausgebildet sind.

10. Anordnung nach Anspruch 2 oder 3 oder 5 oder 8, **dadurch gekennzeichnet, dass** der Transistor (12) oder die Transistoren (T_3; T_4) der Schutzschaltung als ein n-Kanal-Feldeffekttransistor ausgebildet sind.

11. Anordnung nach Anspruch 1, **dadurch gekennzeichnet, dass** die Stabilisierungsschaltung eine Z-Diode umfaßt oder als eine spannnungsabhängige Leitfähigkeitssteuerung eines Transistors oder eine temperaturkompensierte, spannnungsabhängige Leitfähigkeitssteuerung ausgebildet ist.

## Claims

1. Arrangement for voltage supply to a volatile semiconductor memory (1, 1a) with a memory array (2, 2a), at the semiconductor memory (1, 1a) an input voltage (V_STBY) of a predeterminable or specific value for supplying the semiconductor memory being present at a second terminal (7), **characterized in that** the semiconductor memory (1, 1a) is provided with a stabilization circuit (10, 20) for stabilizing the input voltage (V_STBY), which acquires lower impedance in the event of an increased input voltage (V_STBY) above the predeterminable or specific value and acquires higher impedance in the event of an excessively low input voltage (V_STBY) below the predeterminable or specific value.

2. Arrangement according to Claim 1, **characterized in that** the stabilization circuit is designed as a parallel circuit formed by a diode (11) and a transistor (12), the diode (11) being connected to the input voltage (V_STBY) by its anode (A) and to a reference-earth potential (5) by its cathode (K), the said reference-earth potential being present at a third terminal (13) of the semiconductor memory (1), and the transistor (12) being connected between the input voltage (V_STBY) and the reference-earth potential (5) by its switching path (DS) and the base (G) of the transistor (12) being connected to the input voltage (V_STBY).

3. Arrangement according to Claim 1, **characterized in that** a changeover arrangement (8) is arranged for changing over a supply voltage between an operating voltage (V_DD), which is present at a first terminal (6) of the semiconductor memory (1, 1a), and the input voltage (V_STBY), which is present at the second terminal (7) of the semiconductor memory (1, 1a).

4. Arrangement according to Claim 1, **characterized in that** the diode (11) is designed as a zener diode.

5. Arrangement according to Claim 1, **characterized in that** the second terminal (7) of the semiconductor memory (1, 1a) is connected to a supply voltage (Ubatt) via a resistor (R, R2).

6. Arrangement according to Claim 1, **characterized in that** the second terminal (7) of the semiconductor memory (1) is connected to the reference-earth potential (5) via a capacitor (C).

7. Arrangement according to Claim 1, **characterized in that** the semiconductor memory (1) is provided with a protective circuit (14) comprising a series circuit with a plurality of clamp elements (T_3, T_4), which is arranged between the input voltage (V_STBY) and the reference-earth potential (5).

8. Arrangement according to Claim 7, **characterized in that** the clamp elements are designed as transistors (T_3, T_4) connected in series with one another via the switching path (DS), the base (G) of the transistors (T_3, T_4) in each case being connected to a terminal of the switching path (D, S) of the respective transistor (T_3; T_4).

9. Arrangement according to Claim 2 or 8, **characterized in that** the transistor (12) or the transistors (T_3; T_4) of the protective circuit are designed as a field-effect (MOSFET) or bipolar transistor.

10. Arrangement according to Claim 2 or 3 or 5 or 8, **characterized in that** the transistor (12) or the transistors (T_3; T_4) of the protective circuit are designed as an n-channel field-effect transistor.

11. Arrangement according to Claim 1, **characterized in that** the stabilization circuit comprises a zener diode or is designed as a voltage-dependent conductivity control of a transistor or a temperature-compensated, voltage-dependent conductivity control.

## Revendications

1. Dispositif d'alimentation en tension d'une mémoire à semi-conducteurs volatile (1, 1a), comprenant une zone de mémoire (2, 2a), à la mémoire à semi-conducteurs (1, 1a) étant appliquée une tension d'entrée (V_STBY) d'une valeur programmable ou déterminée pour l'alimentation de la mémoire à semi-conducteurs au niveau d'un deuxième port (7),
**caractérisé en ce que**
dans la mémoire à semi-conducteurs (1, 1a) un circuit de stabilisation (10, 20) est prévu pour stabiliser la tension d'entrée (V_STBY), qui en présence d'une tension d'entrée (V_STBY) dépassant la valeur programmable ou déterminée présente une impédance plus basse, et en présence d'une tension d'entrée (V_STBY) trop faible, en dessous de la valeur programmable ou déterminée, présente une impédance plus haute.

2. Dispositif selon la revendication 1,
**caractérisé en ce que**
le circuit de stabilisation se présente sous la forme d'un couplage parallèle d'une diode (11) et d'un transistor (12), la diode (11) étant raccordée par son anode (A) à la tension d'entrée (V_STBY), et par sa cathode (K) à un potentiel de référence (5) appliqué sur un troisième port (13) de la mémoire à semi-conducteurs (1), et le transistor (12), par son trajet de commutation (DS), étant raccordé entre la tension d'entrée (V_STBY) et le potentiel de référence (5), et la base (G) du transistor (12) étant alimentée par la tension d'entrée (V_STBY).

3. Dispositif selon la revendication 1,
**caractérisé en ce qu'**
un dispositif de commutation (8) est prévu pour la commutation d'une tension d'alimentation entre une tension de service (V_DD), appliquée sur un premier port (6) de la mémoire à semi-conducteurs (1, 1a), et la tension d'entrée (V_STBY), appliquée sur le deuxième port (7) de la mémoire à semi-conducteurs (1, 1a).

4. Dispositif selon la revendication 1,
**caractérisé en ce que**
la diode (11) présente la forme d'une diode de Zener.

5. Dispositif selon la revendication 1,
**caractérisé en ce que**
le deuxième port (7) de la mémoire à semi-conducteurs (1, 1a) est relié par une résistance (R, R2) à une tension d'alimentation (Ubatt).

6. Dispositif selon la revendication 1,
**caractérisé en ce que**
le deuxième port (7) de la mémoire à semi-conducteurs (1) est relié par un condensateur (C) au potentiel de référence (5).

7. Dispositif selon la revendication 1,
**caractérisé en ce que**
dans la mémoire à semi-conducteurs (1) un circuit de protection (14) est prévu, comprenant un montage en série de plusieurs éléments ressorts (T_3, T_4) et étant disposé entre la tension d'entrée (V_STBY) et le potentiel de référence (5).

8. Dispositif selon la revendication 7,
**caractérisé en ce que**
les éléments ressorts présentent la forme de transistors (T_3, T_4) couplés en série par le trajet de commutation (DS), la base (G) des transistors (T_3, T_4) étant respectivement reliée à un port du trajet de commutation (D, S) du transistor (T_3 ; T_4) respectif.

9. Dispositif selon la revendication 2 ou 8,
**caractérisé en ce que**
le transistor (12) ou les transistors (T_3 ; T_4) du circuit de protection présentent la forme d'un transistor à effet de champ (MOSFET) ou d'un transistor bipolaire.

10. Dispositif selon la revendication 2 ou 3 ou 5 ou 8,
**caractérisé en ce que**
le transistor (12) ou les transistors (T_3 ; T_4) du circuit de protection présentent la forme d'un transistor à effet de champ à canal N.

11. Dispositif selon la revendication 1,
**caractérisé en ce que**
le circuit de stabilisation comprend une diode Z ou présente la forme d'une commande de conductibilité en fonction de la tension d'un transistor ou d'une commande de conductibilité en fonction de la tension et compensée en température.
